# EUROPEAN PATENT APPLICATION

(11) **EP 2 050 727 A2**
(43) Date of publication of application: **22.04.2009**
(21) Application number: 08166645.5
(22) Date of filing: 15.10.2008
(51) Int. Cl.: C04B 35/565, C04B 35/636, C04B 35/638, C04B 38/06, C22C 29/06, C22C 32/00

(54) **Ceramic Molded Product and Manufacturing Method Thereof**

(30) Priority: 15.10.2007 JP 2007268219
(71) Applicant: Pacific Rundum Co., Ltd, Tokyo (JP)
(72) Inventor: Matsuoka, Hajime c/o Pacific Rundum Co.Ltd., Toyama-shi, Toyama (JP); Ono, Takuro c/o Pacific Rundum Co.Ltd., Toyama-shi, Toyama (JP)
(74) Representative: Gambell, Derek

(57) **Abstract**

A method of manufacturing a ceramic molded product includes adding a binder mainly comprising a saccharide and water to a powder of ceramics such as silicon carbide and stirring the same to form an aqueous sludge having a fluidity, casting the sludge into an elastic die, molding the sludge while applying vibrations in a negative pressure state, solidifying the sludge by putting the die in which the sludge is cast to a temperature below freezing point for freeze-drying, and to a temperature where the binder is not frozen completely, then thawing the sludge in the negative pressure state and subliming and evaporating the water content in the binder, taking the molded product solidified in the die out of the die, further dewatering the demolded product by elevating the temperature to a temperature where the saccharide in the binder is dissolved, and then sintering the molded product.

## Description

### TECHNICAL FIELD

The present invention concerns heat dissipation parts, structural parts for semiconductors, and other various kinds of ceramic molded products, as well as a manufacturing method thereof.

### BACKGROUND

Heretofore, ceramic parts have generally been manufactured by cast molding, press molding, extrusion molding, etc. However, it is difficult to mold products of complicate shapes by such molding methods and a method of molding an approximate shape by a mold, and applying machining before sintering (green machining) or machining after sintering to obtain an aimed shape has been adopted generally.

Further, an injection molding method is known as a method of molding a complicate shape. However, since abrasion is caused to a die in view of the structure of an injection molding machine, use of a raw material of coarse particles has been restricted. Further, a draft is necessary for the dies having a protrusion or a vertical plate shape in view of the structure thereof.

On the other hand, a method of molding a preliminary molded product of a ceramic composite product, is described as an example in JP-T No. 2003-505329 (WO 01/007377). In this method, ceramic and a saccharide binder are mixed and deaerated under vacuum to form a slurry, which is cast into a rubber die. Then, after applying vibrations to sufficiently settle fine particles in the slurry, vibrations are stopped and the mixture is placed in a refrigeration device and frozen. A completely frozen molded product is detached from the rubber die and sintered to obtain a preliminary molded product.

In another method disclosed in JP-A No. H08-100204, a water soluble binder such as starch or PVA is dissolved in water, and a ceramic powder for sintering is mixed therewith to form a slurry. The slurry is cast into a cavity of a molding die and the slurry in the cavity is defoamed under vacuum while applying vibrations to a die such a rubber die. Subsequently, the slurry in the cavity is frozen and solidified by cooling the inside of the cavity under pressure with pressurized air and taken out of the die, and the frozen solidified molded product is dried and sintered to manufacture a sintered part.

Further, in the molding method disclosed in JP-A No. H11-58422, a powder is filled in the cavity of a die, a liquid binder of a phenol resin is impregnated into a space between particles of the powder while depressurizing the inside of the cavity and the binder is cured. In this case, the binder is filled while depressurizing the inside of the cavity and then vibrations are applied to the die before curing of the binder.

In the method of removing a dispersion medium of a molded product disclosed in JP-A No. 2002-220286, water as a dispersion medium, a ceramic powder, and a molding binder such as a polysaccharide or peptide are molded without removing the dispersion medium, frozen after detaching from the die frame, and then the pressure is reduced.

In each case of the manufacturing methods disclosed in JP-T No. 2003-505329 and JP-A No. H08-100204, after completely freezing the slurry using a water soluble saccharide binder, the products are taken out of the die, dried and sintered. Accordingly, particles are bonded by the binder in a state where the volume is expanded due to freezing of water as the dispersion medium in the slurry, and bonding between the particles to each other is weak. Therefore, dried molded product before sintering is fragile and it is difficult to form a molded product of a complicate shape or a molded product having protrusion or fin-like shape. Further, also in preliminary machining before sintering, the molded product tends to be clashed or collapsed and cannot be machined.

Further, in the manufacturing method disclosed in JP-A No. H11-58422, while a phenol resin is used as a liquid binder, the liquid binder is difficult to handle with and releases noxious gases during sintering.

In the method of removing the dispersion medium disclosed in JP-A No. 2002-220286, the dispersion medium is removed being frozen and in a depressurized state, since vibrations are not applied during molding, molding cannot be conducted for complicate die.

### SUMMARY OF THE INVENTION

The present invention has been achieved in view of the background as described above and it intends to provide a ceramic molded product capable of easily molding a molded product of a complicate shape or having many protrusions and also capable of preliminary machining before sintering, as well as a manufacturing method thereof.

The invention provides a method of manufacturing a ceramic molded product, which includes stirring a ceramic powder such as of silicon carbide with addition of a binder mainly comprising a saccharide and water, to form an aqueous sludge having fluidity, casting the sludge into an elastic die, molding the same while applying vibrations in a negative pressure state, solidifying the sludge by putting the die in which the sludge is cast to a temperature below the freezing point and to a temperature where water containing the binder dissolved at a high concentration therein is not completely frozen, subsequently thawing the sludge in the negative pressure state and subliming and evaporating the water content in the binder, taking a molded product solidified in the die out of the die, thereby further dewatering the molded product by elevating the temperature to a temperature where the saccharide in the binder is dissolved, and then sintering the molded product to form a ceramic molded product.

The ceramic powder may be of a single grain size, as well as a mixture of powders of different grain sizes. Further, for the die, a rubber die or a foamed resin die is used.

Further, the invention provides a ceramic molded product obtained by adding a binder mainly comprising a saccharide and water to a ceramic powder to form an aqueous sludge, molding the sludge while applying vibrations under the state of a negative pressure approximate to vacuum, solidifying the sludge by putting the temperature of the die in which the slurry is cast to a temperature below the freezing point and to a temperature where water containing the binder dissolved at a high concentration therein is not frozen completely, the molded product having columnar or wall-like protrusions, and sintering the molded product solidified in the die to form a ceramic molded product. The molded product may be formed by impregnating a metal material into a porous ceramic material.

According to the manufacturing method of the ceramic molded product of the invention, a molded product of a complicate shape or a molded product having a number of protrusions can be molded easily, preliminary machining before sintering can also be conducted easily to further facilitate manufacture of a precise molded product or a product having many protrusions. Further, since the saccharide type binder is used, precise molding is possible are wastes can be suppressed during manufacturing steps, noxious wastes and not released thus giving less environmental burdens.

The ceramic molded product according to the invention have complicate protrusions or a number of protrusions or fins and can provide heat dissipation parts or semiconductor parts of high heat dissipation property, heat resistance, and durability.

### BRIEF DESCRIPTION OF DRAWINGS

Fig. 1 is a flow chart showing a manufacturing step of a ceramic molded product in one embodiment of the invention;
Fig. 2 is a perspective view showing a ceramic molded product in one embodiment of the invention; and
Fig. 3 is a perspective view showing a ceramic molded product in another embodiment of the invention.

### DESCRIPTION OF EMBODIMENTS

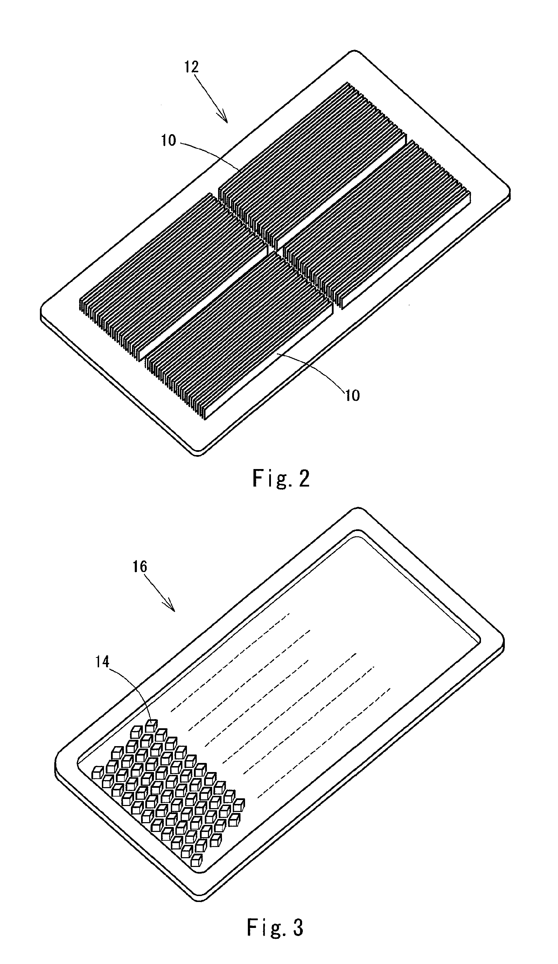

Ceramic molded products of the invention and a manufacturing method thereof are to be described by way of preferred embodiments. The ceramic molded product of the embodiment forms, for example, an electronic heat dissipation part 12 having heat dissipation fins 10 as shown in Fig. 2, and a heat processing part 16 for a semiconductor having a plurality of protrusions 14 as shown in Fig. 3.

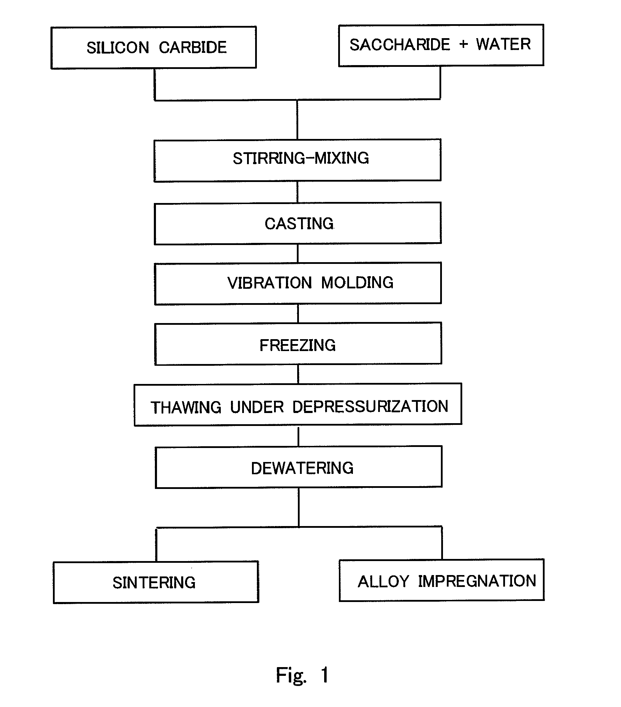

In the method of manufacturing the ceramic molded product of this embodiment, as shown in Fig. 1, silicon carbide particles at high purity with 99 mass% or more of a silicon carbide ingredient and a saccharide binder such as fructose or sucrose are mixed in a vacuum universal stirrer to prepare a starting sludge. The ratio of silicone carbide, saccharide binder, and water is for example, 100:30:8 by mass ratio. Further, a dispersant may be added properly. For the ceramic powder, silicon carbide (SiC), as well as Si₃N₄, Al₂O₃, ZrO₃, etc. can be used. The powder of silicon carbide may be a mixture of a plurality of powders of different grain sizes.

The concentration of the saccharide binder dissolved in water is from 5 to 50 wt% and, preferably, from 15 to 35 wt%. At a lower concentration, the size of the product deviates greatly by freezing after die molding due to volumic expansion caused by the freezing of water to be described later. On the contrary, at a higher concentration, viscosity also increases and the sludge cannot enter to a complicate die thereby providing difficulty in the molding.

Then, the sludge prepared as described above is cast into a soft resin die. The soft resin die includes a rubber die such as made of silicone rubber or a resin die such as made of foamed resin, and any flexible die capable of easy releasing may be used.

Then, the soft resin die in which the sludge is cast is placed in a vacuum apparatus and molded while applying vibrations to the soft resin die in a negative pressure state approximate to vacuum at a gage pressure, for example, of from -0.05 to -0.1 MPa, preferably, at -0.1 MPa. Vibrations are applied at the number of vibrations of 30 to 60 Hz, preferably, at 45 Hz with an amplitude of from 0.2 to 0.6 mm, preferably, 0. 3 mm for about 1 to 2 hr. By the vibrations, foams are removed and the particles of the sludge are filled closely as far as fine portions of the die. Then, the pressure is gradually returned to an atmospheric pressure, the die is taken out of a vibration stand and the binder solution exuded at the upper surface of the die is removed.

Then, the sludge is placed together with the soft resin die to which it is cast in a refrigerator. The refrigerating conditions are at -18 to -30°C for about 12 hr. In this case, the binder formed by dissolving the saccharide at a high concentration into water is less frozen due to freezing point depression and firmly adheres the ceramic particles at high viscosity. Further, even when it is frozen, the volumic expansion is insignificant, and causes less dimensional error after freezing of the die molded product.

Then, the die is taken out of the refrigerator, the molded product is detached from the die and the molded product is placed in a vacuum chamber. In the vacuum chamber, for example, pressure is gradually lowered to about -0.09 MPa by a gage pressure and the product is dried by gradually elevating the temperature. The extent of temperature elevation is from normal temperature to about 200°C. The water content is removed by vacuum drying, preferably, at 110 to 150°C where the saccharide binder is dissolved. The dried molded product is optionally applied with preliminary machining and then sintered, for example, at 1300 to 1800°C for about 3 hr. The sintered molded product is optionally applied with predetermined finishing fabrication to form a product. Further, as shown in the branch on the right at the lower end of the flow chart in Fig. 1, aluminum or other metal or an alloy thereof may be impregnated into the molded product.

According to the ceramic molded product and the manufacturing method thereof by the vibration molding of this embodiment, even a fine structure can be cast reliably, and a precision structural product or columnar or wall-like protrusions can also be molded easily at high accuracy. In addition, the molded product dried after freezing has high strength and can be put to preliminary machining before sintering, and precise and accurate molding is possible. Accordingly, machining before and after sintering may sometimes be saved, and it is possible to save the number of machining steps and the cost, suppress discharge of wastes and decrease the environmental burden. Further, since the product is molded by a soft and elastic die, the draft is not necessary, and no unnecessary forces exert on the molded product upon withdrawing the mold from the die.

Further, the molded product can be molded accurately for protrusions or complicate shape and is applicable easily also to heat dissipation parts or semiconductor parts of a complicate shape. Further, discontinuous grooves or protrusions which are difficult to be formed by machining can easily be provided.

The ceramic molded product and the manufacturing method thereof according to the invention are not restricted to those of the embodiment described above. Metals to be impregnated into the ceramic molded product include, in addition to aluminum, silicon, beryllium, copper, cobalt, iron, manganese, nickel, tin, zinc, silver, gold, boron, magnesium, calcium, barium, strontium, germanium, lead, titanium, vanadium, molybdenum, chromium, yttrium, zirconium, etc. Aluminum, silicon, copper, iron, nickel, cobalt, and titanium are preferred. Aluminum and silicon are particularly suitable.

Further, the vacuum degree and the sintering temperature can be set properly, and the saccharide binder can also be selected properly so long as it is a water soluble saccharide.

### EXAMPLE 1

Then, examples of the present invention are to be described but it should be noted that the invention is not restricted to the following examples. In this example, a powder of silicon carbide described above in the preferred embodiment was mixed with a binder formed by mixing a saccharide to a high concentration approximate to a saturated state to prepare a sludge, which was cast into a silicone rubber die placed on a vibration molding machine, and vibration-molded under the conditions at a number of rotation of 45 Hz, an amplitude of 0.3 mm, and for a vibration time of 120 min. In this case, the silicone rubber die was placed together with a vacuum chamber on the vibration molding machine. The vacuum condition was about at -0.098 MPa. Then, after refrigeration at -30°C for 10 hr, temperature was gradually elevated from -30°C to 200°C. During temperature elevation, the cast product was dried under moisture control in a negative pressure state of -0.06 MPa. Then, the product was sintered at 1800°C in vacuum to form a porous silicon carbide molded product.

Further, an alloy such as Al was impregnated into the molded product. The filling ratio of the obtained silicon carbide complex product was 73%, the heat conductivity was 210 W/mK, and bubbles remaining in the inside were not recognized.

A comparative example to the example described above is to be described below.

By using the same sludge as in Example 1 and after casting the sludge into a silicone rubber die at a pressure of 2.0 Kgf/cm², the sludge was pressed for 5 min. Then, applied pressure was removed and the cast product was frozen at -30°C for 12 hr. Then, the temperature was elevated to -30 to 200°C and the product was dried under a controlled humidity. After completion of drying, it was released from the die to obtain a molded product and, after sintering the molded product at 1500°C in a vacuum state, an alloy was impregnated in the same manner as in the example to prepare a silicon carbide composite product. The filling ratio of silicon carbide was 64%, the heat conductivity was as low as 150 W/mK and, in addition, a number of large bubbles were observed in the inside of the molded product.

### EXAMPLE 2

As the ceramic powder, coarse particles with 60 µm central grain size and fine particles with 15 µm of central grain size comprising SiC were mixed at 6: 4 mass ratio, to which 30 parts of an aqueous binder solution of 30 wt% sucrose was mixed and stirred in a mixer for 30 min under vacuum to prepare a starting material.

A resin mold of 200 x 100 mm size having a plurality of cavities each of 4 mm diameter and 8 mm depth was fixed in a vacuum chamber, set on a vibration table, and the starting material was charged while applying vibrations.

Further, a cover for the vacuum chamber was closed, deaeration was conducted by a vacuum pump and vibrations (at a high number of vibration, for example, of 60 hz) was applied such that the starting material was filled sufficiently in the cavities.

Vacuum was broken at the instance bubbles were generated no more, to return the pressure to an ambient pressure and, further, the number of vibrations was returned to an appropriate number and vibrations were continued for about 1 hr to promote deposition of the starting material.

After settling still for 30 min, an excess liquid binder was removed, the product was placed in a refrigeration chamber for 8 hr and solidified. Then, the resin mold was released to obtain a frozen product having a plurality of protrusions. In this state, while the ceramic powder was adhered and solidified by the binder, the powder contained less water content and not in a frozen state due to freezing point depression.

Further, the frozen product was placed in the vacuum chamber again and thawed to a normal temperature under a negative pressure. It was transferred to a high temperature vessel and dewatered for 10 hr to obtain a molded product before sintering. The product was sintered in vacuum under the conditions at 1650°C and for retention time of 4 hr to obtain a porous product. The obtained porous product had no pore defects in the inside, had a bulk density of 3.17 g/cm³ and a porosity of 31 vol%. When the heat conductivity of the porous product was measured, it was 55 W/mK and the thermal expansion coefficient was 3.5 ppm/K. Further, when Al was penetrated into the porous product, it showed a high conductivity of 230 W/mK.

Comparative examples are shown below.

When the same starting material as in Example 2 was used and molding was conducted in the same manner by using a usual chemical resin type water soluble binder (acrylic emulsion) not using saccharide and the product was placed in a refrigerating chamber, the water content in the binder was crystallized to cause a number of cracks at the surface and the inside of the molded product.

Molding was conducted by using the same die as in Example 2 and applying vibrations without deaeration under vacuum to obtain a molded product. However, the starting material was not filled in a portion of the cavities and pores were present to some extent in the inside.

The same die as in Example 2 was used and the same procedures were conducted as far as demolding in the same manner as Example 2. When the demolded work was transferred as it was from the refrigeration chamber to a high temperature vessel and dewatered and solidified, the protruded portions of the molded product were collapsed or edge portions were flown out from the molded product due to the effect of the water content in the binder and the water content in the atmospheric air and the work lost its original form.

## Claims

1. A method of manufacturing a ceramic molded product, **characterized by** stirring a ceramic powder with addition of a binder mainly comprising a saccharide and water, to form an aqueous sludge having fluidity, casting the sludge into an elastic die, molding the same while applying vibrations in a negative pressure state, solidifying the sludge by putting the die in which the sludge is cast to a temperature below 0°C and to a temperature where water containing the binder dissolved at a high concentration therein is not completely frozen, subsequently thawing the sludge in the negative pressure state and subliming and evaporating the water content in the binder, taking a molded product solidified in the die out of the die, thereby further dewatering the molded product by elevating the temperature to a temperature where the saccharide in the binder is dissolved, and then sintering the molded product to form a ceramic molded product.

2. The method according to claim 1, wherein the ceramic powder is a mixture of powders of different grain sizes.

3. The method according to any preceding claim, wherein the die is a rubber die or a foamed resin die.

4. The method according to any preceding claim, wherein the saccharide in the binder is dissolved in water at a temperature below the freezing point for freeze drying and at a concentration where it is not completely frozen by freezing point depression.

5. The method according to any preceding claim, wherein the ceramic powder comprises silicon carbide.

6. A ceramic molded product, **characterized by** being prepared by adding a binder mainly comprising saccharide and water to a ceramic powder to form an aqueous sludge, and molding the sludge while applying vibrations under the state of a negative pressure approximate to vacuum, solidifying the sludge by putting the die in which the sludge is cast to a temperature below the freezing point for freeze-drying and to a temperature where the binder is not frozen completely, the molded product having columnar or wall-like protrusions, and sintering the molded product solidified in the die.

7. A ceramic molded product according to claim 5, wherein a metal material is impregnated into a porous ceramic material.

8. A ceramic molded product according to claim 6 or 7, wherein the ceramic powder comprises silicon carbide.
